(19) **Europäisches Patentamt**
**European Patent Office**
**Office européen des brevets**

(11) **EP 4 727 021 A1**

(12) **EUROPEAN PATENT APPLICATION**

(43) Date of publication:
**15.04.2026 Bulletin 2026/16**

(21) Application number: **25206311.0**

(22) Date of filing: **02.10.2025**

(51) International Patent Classification (IPC):
*H04B 1/12* (2006.01)     *H04B 1/525* (2015.01)

(52) Cooperative Patent Classification (CPC):
**H04B 1/525; H04B 1/123**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **08.10.2024 KR 20240136819**

(71) Applicant: **Samsung Electronics Co., Ltd.**
**Suwon-si, Gyeonggi-do 16677 (KR)**

(72) Inventors:
• **KIM, Daeyoung**
  **16677 Suwon-si (KR)**
• **YU, Hyunseok**
  **16677 Suwon-si (KR)**

(74) Representative: **Marks & Clerk LLP**
**15 Fetter Lane**
**London EC4A 1BW (GB)**

(54) **INTERFERENCE CANCELLATION CIRCUIT AND OPERATING METHOD THEREOF, AND WIRELESS COMMUNICATION DEVICE**

(57)     An interference cancellation circuit may include a kernel generation circuit configured to generate an interference model based on a transmission signal, an adaptive filter configured to estimate coefficients for the interference model based on an adaptive algorithm to generate an interference estimation signal, and filter out the interference estimation signal from a received signal to generate an interference cancellation signal, and a parameter control (PC) circuit configured to generate a control signal for controlling at least one parameter of the adaptive algorithm based on transmission signal information of the transmission signal and transmit the control signal to the adaptive filter.

FIG. 3

**Description**

BACKGROUND

One or more embodiments of the present application relate to an interference cancellation circuit and an operating method thereof, and more particularly, to an interference cancellation circuit for removing intermodulation interference based on relative delay between transmission signals and an operating method thereof, and a wireless communication device.

Wireless communication systems may employ various techniques to increase throughput. For example, wireless communication systems may adopt carrier aggregation (CA), evolved universal terrestrial radio access (E-UTRA) and new radio (NR) dual connectivity (EN-DC), multiple-input and multiple-output (MIMO), and the like to increase communication capacity by using multiple antennas. As techniques for increasing transmission capacity are adopted, the transmitter may be able to transmit signals with high complexity, while the receiver may be required to process signals with high complexity.

Interference signals may prevent the receiver from processing the signal received through the antenna, and interference signals may occur in a variety of ways. For example, interference signals may include inter-cell interference, which is a signal received from a neighboring base station at the boundary of a serving base station, intra-cell interference, which corresponds to a wireless signal of another terminal within the coverage area of the serving base station, and channel interference.

In addition to interference signals received through the antenna, there are also interference signals generated when a transmission signal within the terminal leaks into the receiving path or is coupled onto the receiving path. In the case of self-interference signals generated within the terminal, the amplified transmission signal is fed back as an interference signal, which may have a significant impact on the deterioration of reception sensitivity. Recently, technology development is actively underway to remove interference signals caused by intermodulation (IMD) between transmission signals received through multiple transmission paths using adaptive algorithms. However, when the channel characteristics of the interference signal (e.g., resource block (RB) size, etc.) suddenly change, there is a problem that the convergence speed of the adaptive algorithm for removing the interference signal decreases, resulting in deterioration of the interference removal performance.

SUMMARY

One or more embodiments of the present application provide an interference cancellation circuit for effectively removing an interference signal when the channel characteristics of the interference signal suddenly change, an operating method thereof, and a wireless communication device.

According to an aspect of the present disclosure, there is provided an interference cancellation circuit including a kernel generation circuit configured to generate an interference model based on a transmission signal, an adaptive filter configured to estimate coefficients for the interference model based on an adaptive algorithm to generate an interference estimation signal, and filter out the interference estimation signal from a received signal to generate an interference cancellation signal, and a parameter control (PC) circuit configured to generate a control signal for controlling at least one parameter of the adaptive algorithm based on transmission signal information of the transmission signal and transmit the control signal to the adaptive filter.

According to another aspect of the present disclosure, there is provided a method of operating an interference cancellation circuit including generating an interference model based on a transmission signal, generating a control signal for controlling at least one parameter of an adaptive algorithm in an adaptive filter, based on transmission signal information received from a transmission filter, generating an interference estimation signal by estimating coefficients for the interference model, based on the adaptive algorithm updated through the control signal, and filtering out the interference estimation signal from a received signal.

According to another aspect of the present disclosure, there is provided a wireless communication device including a transmission filter electrically connected to a first antenna, a reception filter electrically connected to a second antenna, and an interference cancellation circuit configured to generate an interference estimation signal based on an adaptive algorithm, filter out the interference estimation signal from a received signal, and control at least one parameter of the adaptive algorithm based on transmission signal information received from the transmission filter.

At least some of the above and other features of the invention are set out in the claims.

BRIEF DESCRIPTION OF DRAWINGS

Embodiments of the inventive concept will be more clearly understood from the following detailed description taken in conjunction with the accompanying drawings in which:

FIG. 1 illustrates an example of a case where the channel characteristics of an interference signal change according to an embodiment;

FIG. 2 is a block diagram illustrating an example of self-interference by a transmission signal according to an embodiment;

FIG. 3 is a block diagram illustrating an example of a wireless communication device according to an embodiment;

FIG. 4 is a block diagram illustrating an example of an interference cancellation circuit according to an embodiment;

FIG. 5 is a block diagram illustrating an example of a parameter control (PC) circuit according to another embodiment;

FIG. 6 is a diagram illustrating the operation of an interference cancellation circuit, according to an embodiment;

FIG. 7 is a block diagram illustrating another example of an interference cancellation circuit according to an embodiment;

FIG. 8 is a flowchart for explaining an operation method of an interference cancellation circuit according to an embodiment;

FIG. 9 is a flowchart for explaining an operation method of an interference cancellation circuit according to an embodiment;

FIG. 10A is a graph showing the operation of an interference cancellation circuit, according to a comparative embodiment;

FIG. 10B is a graph showing the operation of an interference cancellation circuit, according to an embodiment;

FIG. 11A is a graph showing the operation of an interference cancellation circuit, according to a comparative embodiment;

FIG. 11B is a graph for comparing and explaining the operation of an interference cancellation circuit, according to an embodiment, and the operation of an interference cancellation circuit, according to a comparative embodiment; and

FIG. 12 is a block diagram of a wireless communication device according to an embodiment.

DETAILED DESCRIPTION

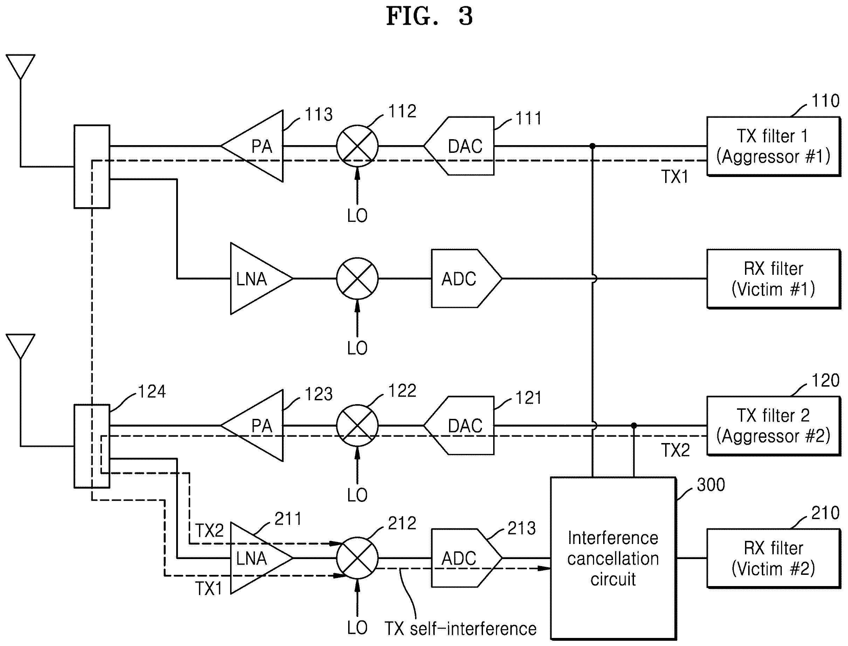

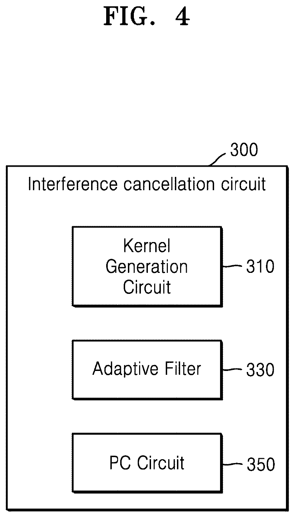

Hereinafter, embodiments of the inventive concept are described in detail with reference to the attached drawings. Although embodiments of the inventive concept are illustrated in the drawings and described in detail in connection therewith, they are not intended to limit the various embodiments of the inventive concept to a specific form. For example, it is apparent to those skilled in the art that the embodiments of the inventive concept may be variously modified.
An interference cancellation circuit 300 according to an embodiment may be included in a wireless communication device (e.g., a terminal) that performs wireless communication based on at least one transmission path (i.e., at least one antenna).
An up-link (UL) block according to an embodiment may include a transmit radio frequency (RF) chain (e.g., a transmission filter), and a down-link (DL) block may include a receive RF chain (e.g., a reception filter).
In an embodiment, at least a portion of a transmitted signal from a UL block (or a transmission filter) may leak into a DL block (or the reception filter) and cause interference (e.g., self-interference). In this case, the transmission signal from the UL block (or transmission filter) may be recognized as an interference signal from the perspective of the DL block (or reception filter). Hereinafter, at least a portion of the transmission signal may be received by the DL block (or the reception filter) as an interference signal.

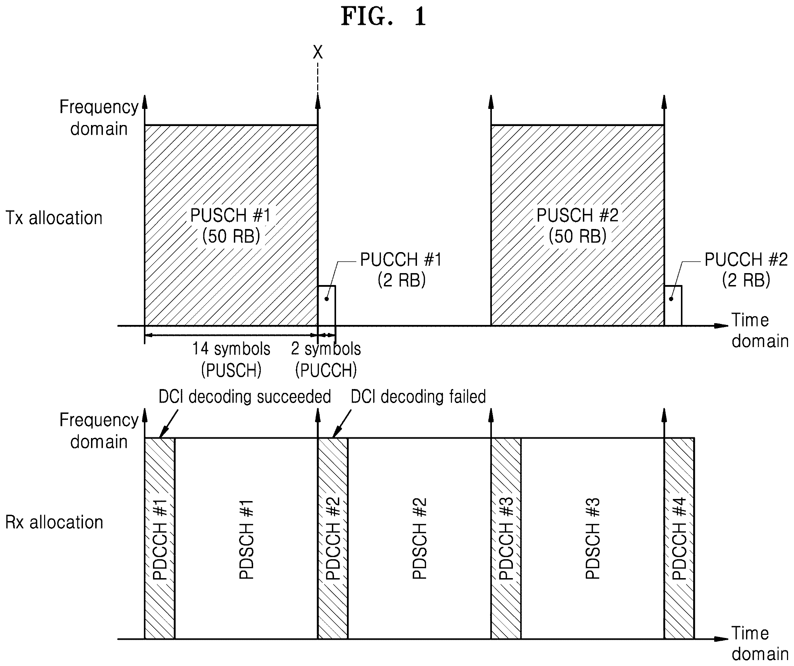

FIG. 1 illustrates an example of a case where the channel characteristics of an interference signal change according to an embodiment.
In detail, FIG. 1 illustrates a time-frequency resource allocation graph for a transmit signal (Tx allocation), represented in resource blocks (RB) units, alongside a time-frequency resource allocation graph for a receive signal (Rx allocation). At a receiving end of a device in FIG. 1, it is assumed that there is self-interference due to intermodulation between transmission signals, and that the receiving end of the device removes interference signals from the received signals by using an interference cancellation circuit (300 in FIG. 3) including an adaptive filter (330 in FIG. 4). In this case, the adaptive filter 330 may filter out interference signals from a received signal based on an adaptive algorithm (e.g., a recursive least squares (RLS) algorithm).

Referring to FIG. 1, in the time-frequency resource allocation graph for the transmission signal (Tx allocation), a transmission signal PUSCH (50 RB) and a transmission signal PUCCH (2 RB) may be alternately allocated for each UL slot. In the time-frequency resource allocation graph for the received signal (Rx allocation), a received signal PDCCH and a received signal PDSCH may be allocated alternately for each DL slot.

When the transmission signal PUSCH #1 changes to the transmission signal PUCCH #1 at the UL slot boundary X, the interference signal may also change as a resource block (RB) size of the transmission signal suddenly changes (e.g., from 50 RB to 2 RB). The convergence speed of the adaptive filter 330 (e.g., coefficients of the adaptive filter 330) is rapidly reduced due to interference signals caused by the transmission signal PUCCH (2 RB), and as a result, decoding of the downlink control information (DCI) of the received signal PDCCH #2 may fail. This phenomenon may occur with high frequency because the UL specifications of LTE and/or NR allow for independent channel allocation and independent power allocation per slot and symbol.

Therefore, the interference cancellation circuit 300 according to an embodiment may adaptively control parameters of an adaptive algorithm according to the characteristics of a transmission signal based on transmission signal information about the characteristics of the transmission signal, thereby improving the convergence speed of the adaptive filter (e.g., coefficients of the adaptive filter).

Furthermore, the interference cancellation circuit 300 according to an embodiment may effectively remove interference signals at a receiving end based on low system complexity by improving the convergence speed of an adaptive filter, thereby improving overall communication performance.

In FIG. 1, for the convenience of description, a situation in which the RB size of the transmission signal decreases is used as an example, but it is not limited thereto, and the interference cancellation circuit 300 according to the embodiment may be applied to various situations in which the characteristics of the transmission signal change (e.g., a situation in which the RB size of the transmission signal increases).

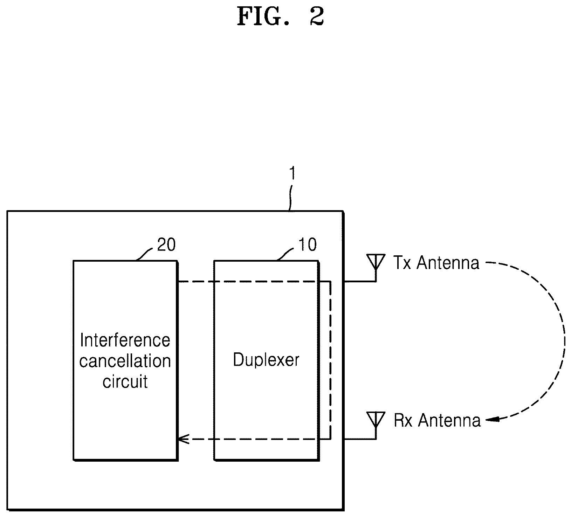

FIG. 2 is a block diagram illustrating an example of self-interference by a transmission signal according to an embodiment.

Referring to FIG. 2, an electronic device 1 may include a duplexer 10 and an interference cancellation circuit 20. The electronic device 1 may correspond to a user equipment (UE). The interference cancellation circuit 20 may be implemented as a digital circuit or at least one processor.

In an embodiment, the duplexer 10 may transmit and receive signals through a transmitting antenna and a receiving antenna. The duplexer 10 may be connected to the transmitting antenna and the receiving antenna. For example, each of the transmitting antenna and receiving antenna may be connected to a transmitting radio frequency (RF) chain and a receive RF chain through the duplexer 10. The duplexer 10 may receive a wireless signal through the receive RF chain and transmit a baseband signal to an external device through the transmit RF chain.

In an embodiment, in the case of the electronic device 1 including the transmitting antenna and the receiving antenna connected through the duplexer 10, feedback of a transmitting signal based on the transmitting antenna and the receiving antenna adjacent to each other may occur. In addition, because the duplexer 10 is connected to both the transmit RF chain and the receive RF chain, at least a portion of the transmit signal from the transmit RF chain may leak into the receive RF chain. Interference may occur when the leaked signal is input into the receive RF chain. In addition, when a signal leaks from at least two transmit RF chains to the receive RF chain, intermodulation may occur between the signals leaked through the two or more transmit RF chains, and interference due to the intermodulation (hereinafter, intermodulation interference) may also occur. The interference may be referred to as including both the self-interference and the intermodulation interference.

The interference cancellation circuit 20 may remove the interference (including the self-interference and the intermodulation interference). For example, the interference cancellation circuit 20 may include an adaptive filter that changes coefficients (e.g., coefficients for an interference model) to converge the filter to an optimal state. The interference cancellation circuit 20 may remove interference by updating the filter coefficients so that an error, which is a difference between the received signal and an interference estimation signal, converges to 0. A detailed description of the interference cancellation circuit 20 is provided below.

FIG. 3 is a block diagram illustrating an example of a wireless communication device according to an embodiment.

Referring to FIG. 3, a first transmission signal TX1 and a second transmission signal TX2 may be transmitted. For example, the first transmission signal TX1 may be filtered to only a desired frequency band through the first transmission filter aggressor #1 110 and converted from a digital signal to an analog signal through a first digital to analog converter (DAC) 111. Thereafter, the transmission frequency of the first transmission signal TX1 is up-converted to the LO frequency received from the local oscillator LO through a first mixer 112, amplified through a first power amplifier PA 113, and then transmitted to an external device (e.g., a base station) through an antenna.

The second transmission signal TX2 may be filtered to only the desired frequency band through the second transmission filter aggressor #2 120 and converted from a digital signal to an analog signal through a second DAC 121. Thereafter, the transmission frequency of the second transmission signal TX2 is up-converted by the LO frequency received by a second mixer 122, amplified by a second power amplifier PA 123, and then transmitted to the external device through the antenna.

According to various embodiments, the electronic device 1 may perform carrier aggregation or dual connectivity, and the first transmission filter Aggressor #1 110, the second transmission filter Aggressor #2 120, and the reception filter Victim #2 210 may all be in an on state. In this case, when self-interference occurs, the first transmission signal TX1 amplified through the first PA 113 may be coupled onto a neighboring receive RF chain. For example, the first transmission signal TX1 may be input to a low noise amplifier LNA 211 of the receive RF chain as a reception signal. In addition, the second transmission signal TX2 may leak from the transmit RF chain connected through the duplexer 124. That is, the second transmission signal TX2 may be input to the low noise amplifier 211 as a reception signal through a duplexer 124. The first transmission signal TX1 and the second transmission signal TX2 generate interference signals near the reception frequency due to the nonlinear characteristics of the receive RF chain, which are down-converted again by the LO frequency received by a third mixer 212 and may be converted into a digital signal through an analog to digital converter ADC 213. In addition to the nonlinear characteristics of the receive RF chain, interference due to intermodulation may also occur between signals leaking through two or more transmit RF chains. Thereafter, the interference signal generated by the first transmission signal TX1 and the second transmission signal TX2 may be removed through the interference cancellation circuit 300.

The interference cancellation circuit 300 may further include a kernel generation circuit 310 and an adaptive filter 330. The kernel generation circuit 310 may be a circuit that receives an interference signal (e.g., at least a portion of the first transmission signal TX1, and/or at least a portion of the second transmission signal TX2) and reproduces (or regenerates) an interference model. The interference model may refer to a machine learning model, or a mathematical model that represents the characteristics of the interference signal, and the kernel generation circuit 310 may use a kernel to capture patterns or correlations in data and represent the inference of interference on a signal. The adaptive filter 330 may generate an interference estimation signal by estimating the coefficients of the kernel generation circuit 310 (i.e., the coefficients of the interference model), and the interference cancellation circuit 300 may perform filtering by subtracting the interference estimation signal from the received signal. For example, the adaptive filter 330 may perform filtering based on the RLS algorithm to compute parameters (coefficients) of the adaptive filter 330 in real-time, minimizing an error between a predetermined desired output signal and the actual output of the adaptive filter 330. The interference cancellation circuit 20 of FIG. 2 may correspond to the interference cancellation circuit 300 of FIG. 3.

FIG. 4 is a block diagram illustrating an example of an interference cancellation circuit according to an embodiment.

Referring to FIG. 4, an interference cancellation circuit 300 may include a kernel generation circuit 310, an adaptive filter 330, and a parameter control circuit (hereinafter referred to as a parameter control (PC) circuit) 350.

In an embodiment, the kernel generation circuit 310 may receive a plurality of transmission signals and reproduce (regenerate or update) an interference model. The reproduced interference model may include both active and passive interference signals. The plurality of transmission signals may be transmission signals of a plurality of transmit RF chains. The kernel generation circuit 310 may receive the plurality of transmission signals and generate a plurality of interference model signals. For example, a first kernel generation circuit may receive all transmission signals of the first transmit RF chain to the Nth transmit RF chain and generate a first interference model signal based thereon. An Nth kernel generation circuit may receive all transmission signals of the first transmit RF chain to the Nth transmit RF chain and generate an Nth interference model signal. In an embodiment, the kernel generation circuit 310 may retrieve a pre-stored interference model from a memory, and update it based on the transmission signals.

In an embodiment, the adaptive filter 330 may generate an interference signal (e.g., an interference estimation signal) by estimating the coefficients of the kernel generation circuit 310, and may perform filtering of the interference signal by subtracting the interference signal (e.g., the interference estimation signal) from the received signal. According to the embodiment, the adaptive filter 330 may be based on at least one of the adaptive algorithms, such as the RLS algorithm, a least mean square (LMS) algorithm using the stochastic gradient descent method, and a dichotomous coordinate descent (DCD)-RLS algorithm.

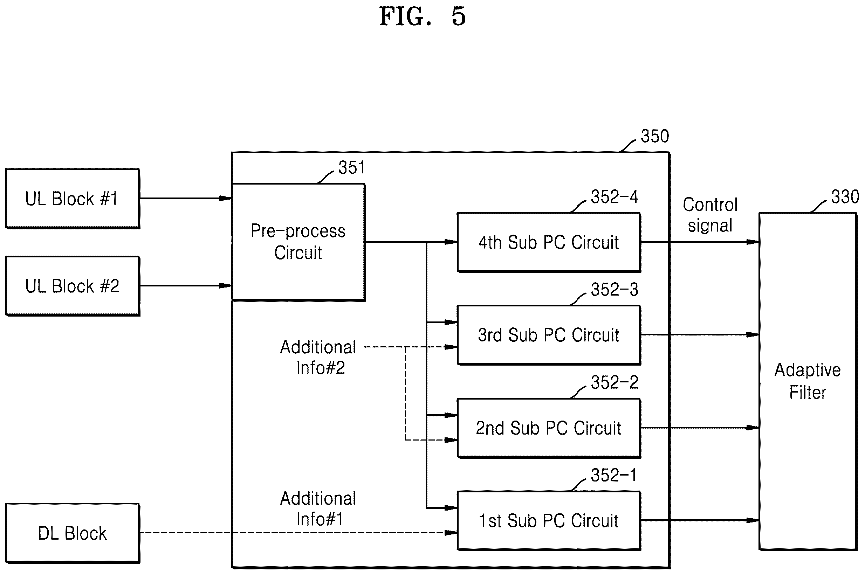

In an embodiment, the PC circuit 350 may receive a transmission signal from at least one UL block. That is, the PC circuit 350 may receive transmission signal information from a transmission filter of at least one UL block (e.g., the first transmission filter 110 and/or the second transmission filter 120 of FIG. 3). At least one parameter of the adaptive algorithm may be controlled based on the above transmission signal information. Here, the transmission signal information is symbol unit information of an up-link (UL) signal, and may include RB size information, offset change information, bandwidth part (BWP) setting change information, system bandwidth (BW) change information, and information indicating whether a carrier component (CC) is activated/deactivated. At least one of the parameters may include a regularization value, a variable forgetting factor, an initialization of a correlation matrix, and a number of taps of the adaptive filter. A description of the specific operation of the PC circuit 350 is described in FIG. 5 below.

FIG. 5 is a block diagram illustrating an example of a PC circuit according to another embodiment.

Referring to FIG. 5, a PC circuit 350 may include a pre-process circuit 351, a 1st sub PC circuit 352-1, a 2nd sub PC circuit 352-2, a 3rd sub PC circuit 352-3, and a 4th sub PC circuit 352-4.

A transmission signal transmitted from at least one UL block of FIG. 5 may be recognized as an interference signal from the perspective (self-interference situation) of a DL block (or reception filter). For example, at least a portion of the transmission signal may be received by the DL block (or the reception filter) as an interference signal.

The pre-process circuit 351 may receive transmission signal information from at least one UL block. For example, the pre-process circuit 351 may receive transmission signal information from the first transmission filter (Tx filter 1 110 in FIG. 3) of the first UL block (UL Block #1), and the pre-process circuit 351 may receive transmission signal information from the second transmission filter (Tx filter 2 120 in FIG. 3) of the second UL block (UL Block #2). The pre-process circuit 351 may generate control information including at least one of a bandwidth variation of the interference signal(e.g., a bandwidth change amount of the interference signal), a change point of the interference signal(e.g., a change point in time of the interference signal), or a change position of the interference signal in the frequency domain, based on the received transmission signal information. In this case, at least the portion of the transmission signal may be perceived as an interference signal from the perspective (e.g. in the self-interference situation) of the DL block (or reception filter). The pre-process circuit 351 may transmit transmission signal information and control information to the 1st sub PC circuit 352-1, the 2nd sub PC circuit 352-2, the 3rd sub PC circuit 352-3, and the 4th sub PC circuit 352-4.

Each of the 1st sub PC circuit 352-1, the 2nd sub PC circuit 352-2, the 3rd sub PC circuit 352-3, and the 4th sub PC circuit 352-4 may be a circuit for controlling parameters of the adaptive algorithm (e.g., the RLS algorithm) in the adaptive filter (330 of FIG. 4), based on transmission signal information and control information.

The 1st sub PC circuit 352-1 may control a regularization value among at least one parameter of the adaptive algorithm. The following Equation 1 may represent a cost function J(n) of the adaptive filter (330 in FIG. 4), based on an adaptive algorithm (e.g., RLS algorithm).

[Equation 1]

$$J(n) = \sum_{i=1}^{n} \lambda^{n-i} |e(i)|^2 + \delta(n)\|\mathbf{w}(n)\|^2$$

Here, $e(i)$ may denote an error of the i-th received signal sample, $\lambda$ ($0 < \lambda \leq 1$) may denote a variable forgetting factor, $\delta(n)$ may denote a regularization value in the n-th received signal sample, and $\mathbf{w}(n)$ may denote a coefficient vector of an adaptive filter 330 (e.g., an adaptive filter based on the RLS algorithm) in the n-th received signal sample.

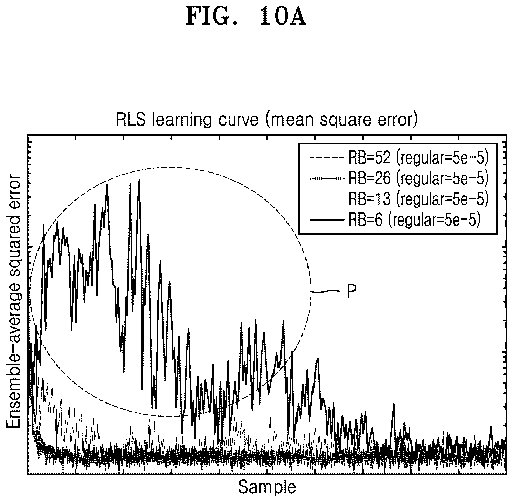

The regularization value $\delta(n)$ is a positive real number weight for the coefficients of the adaptive filter 330, which may prevent overfitting so that the coefficients of the adaptive filter 330 do not change abruptly. However, when the regularization value $\delta(n)$ is set to an excessively great value, a problem may occur in which the error (e.g., mean square error) of the cost function $J(n)$ does not converge quickly, and this problem may be solved through the initialization control of the correlation matrix by the 3rd sub PC circuit 352-3 described below. The parameter drift phenomenon may mean a phenomenon in which the coefficients of the adaptive filter 330 increase without converging, even in a situation in which the error (e.g., mean square error) of the cost function $J(n)$ does not increase, and thus the convergence speed of the adaptive filter 330 becomes very slow (see part P of FIG. 10A). In particular, the parameter drift phenomenon may significantly increase the error of the cost function $J(n)$ in a finite-precision system and slow down the convergence speed of the adaptive filter 330, which may cause a deterioration in the overall communication performance of the device. Therefore, the 1st sub PC circuit 352-1 according to the embodiment may prevent the parameter drift phenomenon in the adaptive filter 330 by controlling the regularization value $\delta(n)$, based on transmission signal information and control information. The 1st sub PC circuit 352-1 may control the regularization value $\delta(n)$ in various ways. For example, the 1st sub PC circuit 352-1 may set the regularization value $\delta(n)$ to the first value when the RB size of the transmission signal (i.e., interference signal) is greater than or equal to the first threshold value, may set the regularization value $\delta(n)$ to the second value when the RB size of the transmission signal (i.e., interference signal) is less than the first threshold value and greater than or equal to the second threshold value, and may set the regularization value $\delta(n)$ to the third value when the RB size of the transmission signal (i.e., interference signal) is less than the second threshold value and greater than or equal to the third threshold value. For another example, the 1st sub PC circuit 352-1 may control the regularization value $\delta(n)$ using a function based on at least one piece of information among the transmission signal information (e.g., information on the RB size, offset, etc. of the transmission signal). For another example, the first sub PC circuit 352-1 may control the regularization value $\delta(n)$,

based on the first additional information additional info #1, transmission signal information, and control information. Here, the first additional information additional info #1 may be DL control information (e.g., signal noise ratio (SNR) information) received from the DL block (e.g., the reception filter of at least one DL block).

The 2nd sub PC circuit 352-2 may control the variable forgetting factor among at least one parameter of the adaptive algorithm. In Equation 1 described above, the variable forgetting factor $\lambda$ is a parameter that gives weight to errors from the past to the present $(0 < \lambda \leq 1)$. For example, as the variable forgetting factor approaches 0, the proportion of the current signal sample increases, which may increase the convergence speed of the adaptive filter 330 (e.g., coefficient of the adaptive filter 330) for changes in the transmission signal (i.e., interference signal), but the estimation performance in the steady state may be weakened. On the other hand, as the variable forgetting factor $\lambda$ approaches 1, the proportion of past signal samples increases, which may improve the estimation performance in steady state, but the convergence speed of the adaptive filter 330 for changes in the transmission signal (i.e., interference signal) may decrease. Accordingly, the 2nd sub PC circuit 352-2 according to the embodiment may adaptively set parameters of the adaptive algorithm when a transmission signal (i.e., an interference signal) changes by controlling the variable forgetting factor, based on the transmission signal information and the control information. The second sub PC circuit 352-2 may control the variable forgetting factor in various ways. For example, the 2nd sub PC circuit 352-2 may set the variable forgetting factor to the fourth value when the RB size of the transmission signal (i.e., interference signal) is greater than or equal to the first threshold value, may set the variable forgetting factor to the fifth value when the RB size of the transmission signal (i.e., interference signal) is less than the first threshold value and greater than or equal to the second threshold value, and may set the variable forgetting factor to the sixth value when the RB size of the transmission signal (i.e., interference signal) is less than the second threshold value and greater than or equal to the third threshold value. For another example, the 2nd sub PC circuit 352-2 may control a variable forgetting factor using a function based on at least one piece of information among the transmission signal information (e.g., information about the RB size, offset, etc. of the transmission signal). For another example, the 2nd sub PC circuit 352-2 may set a variable forgetting factor in a predetermined time order, based on a stored look-up table (LUT) when a trigger signal due to a change in the RB size of a transmission signal (i.e., an interference signal) is received. In particular, the second sub PC circuit 352-2 sets the variable forgetting factor to a small value close to 0 in the early stage of filtering in order to quickly track the change in the transmission signal (i.e., interference signal) and sets the variable forgetting factor to a large value close to 1 in the later stage of filtering in order to improve the estimation performance in the steady state, thereby improving the convergence speed of the adaptive filter 330 (e.g., coefficient of the adaptive filter 330). For another example, the second sub PC circuit 352-2 may control a variable forgetting factor, based on the second additional information additional info #2, transmission signal information, and control information. Here, the second additional information additional info #2 may be information indicating whether interference has occurred.

The third sub PC circuit 352-3 may control the initialization of a correlation matrix among at least one parameter of the adaptive algorithm. The initial value of the correlation matrix may affect the convergence speed of the adaptive filter 330 (e.g., coefficients of the adaptive filter 330) based on the SNR of the signal input to the filter tab. For example, when the SNR of the signal input to the filter tab is high, the less the initial value of the correlation matrix is set, the faster the convergence speed of the adaptive filter 330. When the SNR of the signal input to the filter tab is medium, the convergence speed of the adaptive filter 330 tends to be slower than in the case of the aforementioned high SNR, and the sensitivity to the initial value of the correlation matrix tends to be lower. When the SNR of the signal input to the filter tab is low, the sensitivity to the initial value of the correlation matrix is very low, so the greater the initial value of the correlation matrix is set, the better the communication performance of the entire device may be improved.

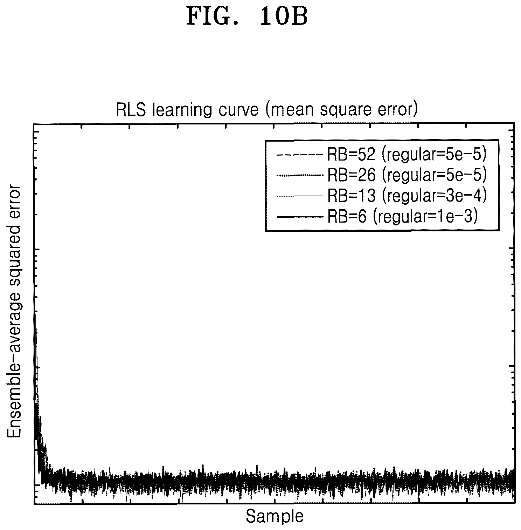

In general, in the convergence state of the adaptive filter 330, the correlation matrix becomes much greater than the initial value. Therefore, when the transmission signal (i.e., interference signal) suddenly changes in the convergence state of the adaptive filter 330, the adaptive filter 330 (or the adaptive algorithm) recognizes the correlation matrix in the previous convergence state as the initial value. Since the correlation matrix in the previous convergence state is much greater than the general initial value, the convergence speed of the adaptive filter 330 (e.g., coefficients of the adaptive filter 330) for the change in the transmission signal (i.e., interference signal) may become very slow (see FIG. 10B). In addition, when the RB size of the transmission signal changes, the coefficients of the adaptive filter 330 may also change as the amount of interference signal input to the reception filter changes (due to the automatic gain control (AGC) operation and the change in analog gain due to the AGC). Accordingly, the 3rd sub PC circuit 352-3 according to the embodiment may adaptively set parameters of the adaptive algorithm when a transmission signal (i.e., an interference signal) changes by controlling the initialization of a correlation matrix based on transmission signal information and control information. The third sub PC circuit 352-3 may control the initialization of the correlation matrix in various ways. For example, the 3rd sub PC circuit 352-3 may set the initialization of the correlation matrix to ON (or OFF) when the RB size of the transmission signal (i.e., the interference signal) is greater than or equal to the first threshold value, and the initialization of the correlation matrix may be set to OFF (or ON) when the RB size of the transmission signal (i.e., the interference signal) is less than the first threshold value. For another example, the 3rd sub PC circuit 352-3 may control the initialization of the correlation matrix using a function based on at least one piece of information among the transmission signal information (e.g.,

information on the RB size, offset, etc. of the transmission signal). For another example, the 3rd sub PC circuit 352-3 may control the initialization of the correlation matrix, based on the second additional information additional info #2, transmission signal information, and control information. Here, the second additional information additional info #2 may be information indicating whether interference has occurred.

The 4th sub PC circuit 352-4 may control the number of taps of the adaptive filter among at least one parameter of the adaptive algorithm. The following Equation 2 represents an equation that approximates the priori estimation error $J'(n)$ of an adaptive filter.

[Equation 2]

$$J'^{(n)} \approx \sigma_o^2 + \frac{M}{n}\sigma_o^2 \quad (n > M)$$

Here, $\sigma_o^2$ represents noise variance, M represents the number of taps of the adaptive filter, and n represents the index of a signal sample. Referring to Equation 2, as the signal sampling index (n) increases, the second term $\frac{M}{n}\sigma_o^2$ of Equation 2 decreases, and it may be confirmed that the priori estimation error $J'(n)$ quickly converges to the noise variance $\sigma_o^2$. On the other hand, as the number M of taps of the adaptive filter increases, the second term $\frac{M}{n}\sigma_o^2$ of Equation 2 increases, so that the priori estimation error $J'(n)$ may be confirmed to converge slowly to the noise variance $\sigma_o^2$. Accordingly, the 4th sub PC circuit 352-4 according to the embodiment may adaptively set parameters of the adaptive algorithm when the transmission signal (i.e., interference signal) changes by controlling the number of taps of the adaptive filter, based on the transmission signal information and the control information. The fourth sub PC circuit 352-4 may control the number of taps of the adaptive filter in various ways. For example, the 4th sub PC circuit 352-4 may set the number of taps of the adaptive filter to 7 when the RB size of the transmission signal (i.e., interference signal) is greater than or equal to the first threshold value, when the RB size of the transmission signal (i.e., interference signal) is less than the first threshold value and greater than or equal to the second threshold value, the number of taps of the adaptive filter may be set to 8, and when the RB size of the transmission signal (i.e., interference signal) is less than the second threshold value and greater than or equal to the third threshold value, the number of taps of the adaptive filter may be set to 9. For another example, the 4th sub PC circuit 352-4 may control the number of taps of the adaptive filter using a function based on at least one piece of information among the transmission signal information (e.g., information on the RB size, offset, etc. of the transmission signal). In particular, the 4th sub PC circuit 352-4 may improve the convergence speed of the adaptive filter 330 (e.g., coefficients of the adaptive filter 330) by setting the number of taps of the adaptive filter to a small number when the RB size of the transmission signal (i.e., interference signal) is reduced.

In FIG. 5, the interference cancellation circuit 300 is illustrated as including the 1st sub PC circuit 352-1, the 2nd sub PC circuit 352-2, the 3rd sub PC circuit 352-3, and the 4th sub PC circuit 352-4, but is not limited thereto, and the interference cancellation circuit 300 according to the embodiment may include a variety of sub PC circuits depending on the parameters of the controlled adaptive algorithm.

As described above, the interference cancellation circuit 300 (e.g., PC circuit 350) according to the embodiment may effectively remove the interference signal from the received signal by adaptively controlling the parameters of the adaptive algorithm, based on the transmission signal information in a situation where the transmission signal (i.e., the interference signal) changes.

Furthermore, the interference cancellation circuit 300 (e.g., PC circuit 350) according to the embodiment may improve the overall communication performance of the device by effectively removing interference signals, based on transmission signal information.

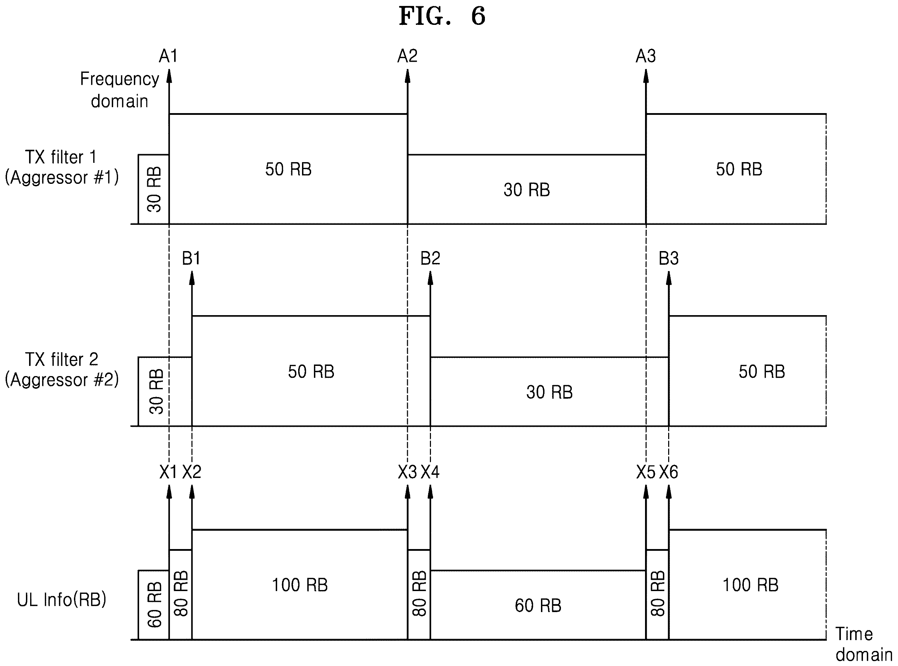

FIG. 6 is a diagram illustrating the operation of an interference cancellation circuit, according to an embodiment.

In detail, FIG. 6 illustrates a time-frequency resource allocation graph for a UL signal, which is transmitted from each of a first transmission filter Tx filter 1 and a second transmission filter Tx filter 2, and is represented in resource blocks (RB) units, and a time-frequency resource allocation graph from an integrated UL signal, represented in resource blocks (RB) units. In FIG. 6, it is assumed that UL signals transmitted from the first transmission filter Tx filter 1 and the second transmission filter Tx filter 2 generate self-interference (e.g., IMD2 interference) in the reception filter.

Referring to FIG. 6, the RB size of the UL signal from the first transmission filter Tx filter 1 may be changed from 30 RB to 50 RB at a UL slot boundary A1, from 50 RB to 30 RB at a UL slot boundary A2, and from 30 RB to 50 RB at a UL slot boundary A3. In addition, the RB size of the UL signal from the second transmission filter Tx filter 2 may be changed from 30 RB to 50 RB at a UL slot boundary B1, from 50 RB to 30 RB at a UL slot boundary B2, and from 30 RB to 50 RB at a UL slot boundary B3. Accordingly, the integrated UL signal, which is a combination of the UL signals transmitted from the first transmission filter Tx filter 1 and the second transmission filter Tx filter 2, may be changed from 60 RB to 80 RB at a UL slot boundary X1, from 80 RB to 100 RB at a UL slot boundary X2, from 100 RB to 80 RB at a UL slot boundary X3, from 80 RB to 60 RB at a UL slot boundary X4, from 60 RB to 80 RB at a UL slot boundary X5, and from 80 RB to 100 RB at a UL slot boundary X6. That is, the UL slot boundary X1 to X6 of the integrated UL signal of FIG. 6 may be a change point in transmission signal information (e.g., RB size of a transmission signal) of at least one UL block (e.g., the first transmission filter Tx filter 1 and the second transmission filter Tx filter 2).

The interference cancellation circuit 300 according to an embodiment may adaptively control at least one parameter of the adaptive algorithm at each change point (i.e., UL slot boundary X1 to X6) of a transmission signal (e.g., RB size) of the first transmission filter Tx filter 1 and the second transmission filter Tx filter 2, based on transmission signal information. The interference cancellation circuit 300 may generate a control signal for controlling at least one parameter at each change point (i.e., UL slot boundary X1 to X6) of a transmission signal (e.g., RB size) of the first transmission filter Tx filter 1 and the second transmission filter Tx filter 2, and transmit the generated control signal to the adaptive filter 330. The adaptive filter 330 updates the parameters of the adaptive algorithm, based on the received control signal, thereby improving the convergence speed of the adaptive filter 330 (e.g., coefficients of the adaptive filter 330) despite changes in the transmission signal information (e.g., RB size of the transmission signal).

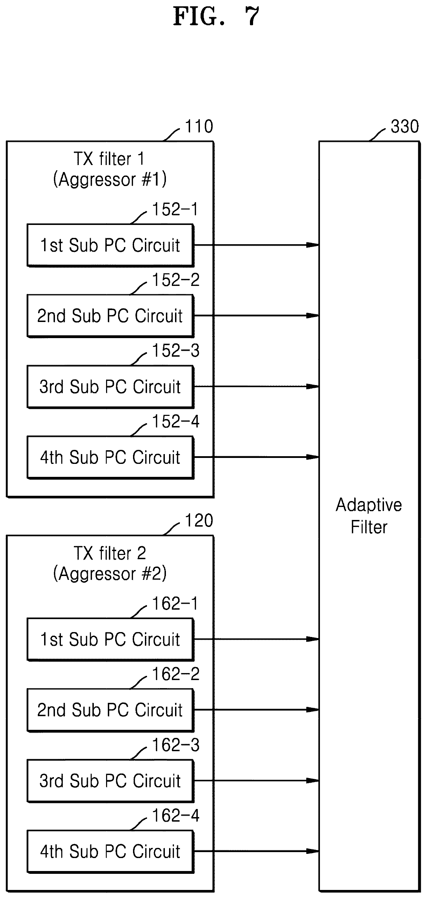

FIG. 7 is a block diagram illustrating another example of an interference cancellation circuit according to an embodiment.

In the above description, it has been described that the first transmission filter (Tx filter 1) 110 and the second transmission filter (Tx filter 2) 120 of at least one UL block transmit transmission signal information to an interference cancellation circuit 300, and the interference cancellation circuit 300 controls at least one parameter of the adaptive algorithm, based on the received transmission signal information. However, because the data size of the above transmission signal information is considerably large, communication delay due to data overload may occur during the transmission process of the transmission signal information.

Therefore, referring to FIG. 7, at least one transmission filter according to another embodiment may control at least one parameter of the adaptive algorithm (e.g., an RLS algorithm) using at least one sub PC circuit. Here, at least one parameter may include a regularization value, a variable forgetting factor, initialization of a correlation matrix, and the number of taps of the adaptive filter. For example, the first transmission filter (Tx filter 1) 110 may include the 1st sub PC circuit 152-1, the 2nd sub PC circuit 152-2, the 3rd sub PC circuit 152-3, and the 4th sub PC circuit 152-4. The 2nd transmission filter (Tx filter 2) 120 may include the first sub PC circuit 162-1, the 2nd sub PC circuit 162-2, the 3rd sub PC circuit 162-3, and the fourth sub PC circuit 162-4. For example, the first transmission filter (Tx filter 1) 110 may generate a control signal for controlling at least one parameter of an adaptive algorithm based on transmit signal information of the first transmission filter (Tx filter 1) (i.e., transmit signal information of the first UL block), and transmit the generated control signal (e.g., a signal for a command to set a regularization value, a command to start a variable forgetting factor, a command to initialize a correlation matrix, and a command to set the number of taps of the adaptive filter) to the adaptive filter 330. The second transmission filter (Tx filter 2) 120 may generate a control signal for controlling at least one parameter of the adaptive algorithm based on the transmission signal information of the second transmission filter (Tx filter 2) 120 (i.e., the transmission signal information of the second UL block), and transmit the generated control signal (e.g., a signal for a command to set a regularization value, a command to start a variable forgetting factor, a command to initialize a correlation matrix, and a command to set the number of taps of the adaptive filter) to the adaptive filter 330.

As described above, the transmission filter according to another embodiment may prevent data overload occurring during the transmission process of transmission signal information by controlling parameters of the adaptive algorithm by transmitting a control signal having a small data size to the adaptive filter 330.

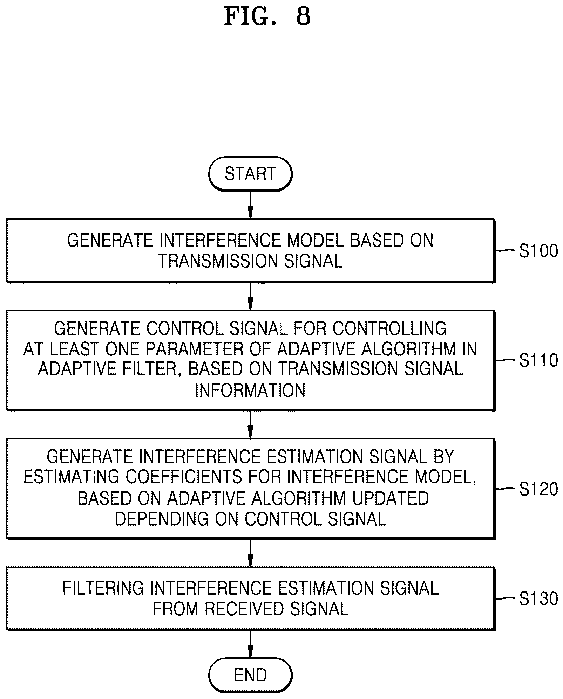

FIG. 8 is a flowchart for explaining an operation method of an interference cancellation circuit according to an embodiment.

Referring to FIG. 8, a method of filtering/cancelling an interference signal by controlling parameters of an adaptive algorithm by an interference cancellation circuit 300 may include operations S100 to S130. In the description of Fig. 8, any description that overlaps with the description of FIGS. 1 to 7 is replaced with the description of FIGS. 1 to 7.

A transmission signal transmitted from at least one UL block (or at least one transmission filter) of FIG. 8 may be recognized as an interference signal from the perspective (e.g., in a self-interference situation) of a DL block (or reception filter). Hereinafter, at least a portion of the transmission signal may be received by the DL block (or the reception filter) as an interference signal.

In operation S100, the interference cancellation circuit 300 may generate an interference model, based on a transmission signal. For example, the kernel generation circuit 310 of the interference cancellation circuit 300 may generate (or reproduce) an interference model by receiving a transmission signal from at least one transmission filter.

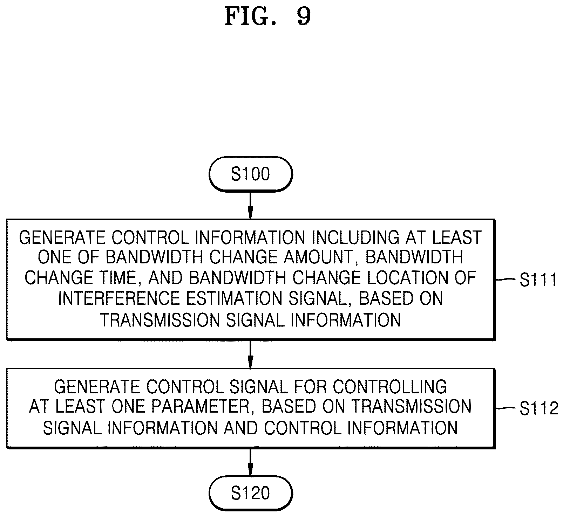

In operation S110, the interference cancellation circuit 300 may generate a control signal for controlling at least one parameter of an adaptive algorithm in an adaptive filter 330, based on transmission signal information. In an embodiment, the interference cancellation circuit 300 may receive transmission signal information from at least one transmission filter (i.e., at least one UL block). Here, the transmission signal information is symbol unit information of a UL signal, and may include RB size information, offset change information, BWP setting change information, system BW change information, and information indicating whether a CC is activated/deactivated. The pre-process circuit 351 of the interference cancellation circuit 300 may generate control information necessary to control at least one parameter of the adaptive algorithm based on the transmission signal information. An explanation of this is described in FIG. 9 below.

In an embodiment, at least one sub PC circuit of the interference cancellation circuit 300 may generate a control signal for controlling at least one parameter of the adaptive algorithm based on the transmission signal information and the control information. Here, at least one parameter of the adaptive algorithm may include a regularization value, a variable forgetting factor, initialization of a correlation matrix, and the number of taps of the adaptive filter. In an embodiment, at least one sub PC circuit may set at least one parameter to a first value when the RB size of the transmission signal (i.e., the interference signal) is greater than or equal to a first threshold value, at least one parameter may be set to a second value when the RB size of the transmission signal (i.e., the interference signal) is less than the first threshold value and greater than or equal to a second threshold value, and at least one parameter may be set to a third value when the RB size of the transmission signal (i.e., the interference signal) is less than the second threshold value and greater than or equal to a third threshold value. In an embodiment, at least one sub PC circuit may control at least one parameter using a function based on at least one piece of information of the transmit signal (e.g., information about the RB size, offset, etc. of the transmit signal).

In an embodiment, at least one sub PC circuit may generate a control signal for controlling the regularization value, based on the transmission signal information, the control information, and the first additional information. Here, the first additional information may be DL control information (e.g., SNR information).

In an embodiment, at least one sub PC circuit may control a variable forgetting factor, based on the transmission signal information, the control information, and the second additional information. Here, the second additional information may be information indicating whether interference has occurred.

In an embodiment, at least one sub PC circuit may control initialization of the correlation matrix, based on the transmission signal information, the control information, and the second additional information. Here, the second additional information may be information indicating whether interference has occurred.

In operation S120, the interference cancellation circuit 300 may generate an interference estimation signal by estimating coefficients for an interference model, based on the adaptive algorithm updated depending on a control signal. Here, the adaptive algorithm may include the RLS algorithm. In operation S130, the interference cancellation circuit 300 may filter (or remove) an interference estimation signal from a received signal. For example, the adaptive filter 330 of the interference cancellation circuit 300 may update at least one parameter of an adaptive algorithm, based on a control signal and generate an interference estimation signal, based on the updated adaptive algorithm. The adaptive filter 330 may filter/remove interference signals by subtracting interference estimation signals from the received signals.

FIG. 9 is a flowchart for explaining an operation method of an interference cancellation circuit according to an embodiment.

Referring to FIG. 9, an operation S110 of generating a control signal by the interference cancellation circuit 300 may include operations S111 and S112. In the description of Fig. 9, any description that overlaps with the description of FIGS. 1 to 8 is replaced with the description of FIGS. 1 to 8. Hereinafter, at least a portion of the transmission signal may be received by the DL block (or the reception filter) as an interference signal.

In operation S111, the interference cancellation circuit 300 may generate control information including at least one of a change in the bandwidth of the interference signal (for example, a bandwidth change amount of the interference signal), a change point of the interference signal (for example, a change point in time of the interference signal(a bandwidth change time)), and a change position of the interference signal in the frequency domain (for example, a bandwidth change location of the interference estimation signal), based on the transmission signal information. In this case, a transmission signal transmitted from at least one UL block (or at least one transmission filter) may be recognized as an interference signal from the perspective (e.g., in a self-interference situation) of a DL block (or a reception filter).

In operation S112, the interference cancellation circuit 300 may generate a control signal for controlling at least one parameter based on transmission signal information and control information. For example, the control signal for controlling at least one parameter may include at least one of a signal for a command to set a regularization value, a command to start a variable forgetting factor, a command to initialize a correlation matrix, and a command to set the number of taps of an adaptive filter.

FIG. 10A is a graph showing the operation of an interference cancellation circuit, according to a comparative embodiment. FIG. 10B is a graph showing the operation of an interference cancellation circuit, according to an embodiment.

In detail, FIG. 10A shows a graph (e.g., RLS learning curve (mean square error)) showing a convergence speed of an error of an interference cancellation circuit according to a comparative embodiment, and FIG. 10B shows a graph (e.g., RLS learning curve (mean square error)) showing a convergence speed of an error of an interference cancellation circuit according to an embodiment. For example, the graph of FIG. 10A illustrates the convergence speed of an adaptive filter (e.g., coefficients of an adaptive filter) according to a comparative embodiment, by RB size of a transmission signal, and the graph of FIG. 10B illustrates the convergence speed of an adaptive filter 330 (e.g., coefficients of the adaptive filter 330) according to an embodiment, by RB size of the transmission signal. In FIGS. 10A and 10B, the transmission signal transmitted from the UL block (or at least one transmission filter) may be recognized as an interference signal from the perspective (e.g., in a self-interference situation) of the DL block (or reception filter). Hereinafter, at least a portion of the transmission signal may be received by the DL block (or the reception filter) as an interference signal.

Referring to FIG. 10A, when the RB size of the transmission signal is small (e.g., when the RB size is 6), it may be observed that the interference cancellation circuit in the comparative embodiment exhibits a significant increase in the error of the adaptive filter (e.g., an error in the cost function of the adaptive filter) or an unstable value (as shown in part P of FIG. 10A) due to a parameter drift phenomenon. As a result, the convergence speed of the adaptive filter (e.g., coefficient of the adaptive filter) in the comparative embodiment is significantly slowed down. Specifically, because the coefficients of the adaptive filter in the comparative embodiment do not converge quickly due to the parameter drift phenomenon (as shown in part P of FIG. 10A), the interference cancellation circuit in the comparative embodiment may not effectively remove the interference signal from the received signal, which may cause the overall communication performance of the device to deteriorate.

Referring to FIG. 10B, when the RB size of the transmission signal is small (e.g., when the RB size is 6), the interference cancellation circuit 300 in the embodiment adaptively sets/controls the corresponding regularization value for each RB size. This adaptive control may prevent the occurrence of the parameter drift phenomenon (e.g., part P of Fig. 10a). As a result, the error in the adaptive filter (e.g., error of the cost function of the adaptive filter) converges quickly from the beginning of filtering (see part R of FIG. 10B). That is, the interference cancellation circuit 300 according to an embodiment may effectively remove an interference signal from a received signal by increasing the convergence speed of an adaptive filter (e.g., coefficients of an adaptive filter) through adaptive normalization control based on control information and transmission signal information (e.g., information about RB size and offset position of the transmission signal, etc.).

Therefore, the interference cancellation circuit 300 according to the embodiment may effectively remove the interference signal by adaptively controlling the parameters (e.g., regularization value) of the adaptive algorithm depending on changes in the interference signal (e.g., transmission signal).

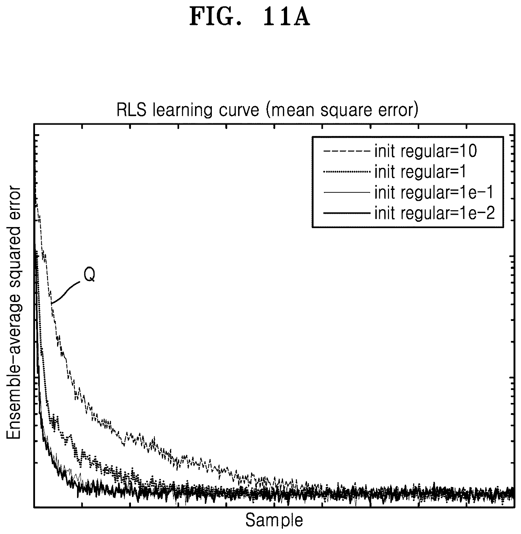

FIG. 11A is a graph showing the operation of an interference cancellation circuit, according to a comparative embodiment.

In detail, FIG. 11A shows a graph (e.g., RLS learning curve (mean square error)) showing the convergence speed of the error in the interference cancellation circuit according to the comparative embodiment. For example, the graph of FIG. 11A may represent the convergence speed of an adaptive filter (e.g., coefficients of an adaptive filter) in the comparative embodiment, with respect to the initial value of a correlation matrix in a high SNR environment (e.g., SNR 30 dB environment).

Referring to FIG. 11A, when the initial value of the correlation matrix is great (e.g., when the initial value of the correlation matrix is 10), the error in the interference cancellation circuit according to the comparative embodiment may be observed to converge slowly (i.e., the convergence speed of the adaptive filter (e.g., the coefficients of the adaptive filter) is significantly slowed down) (see graph Q in FIG. 11A).

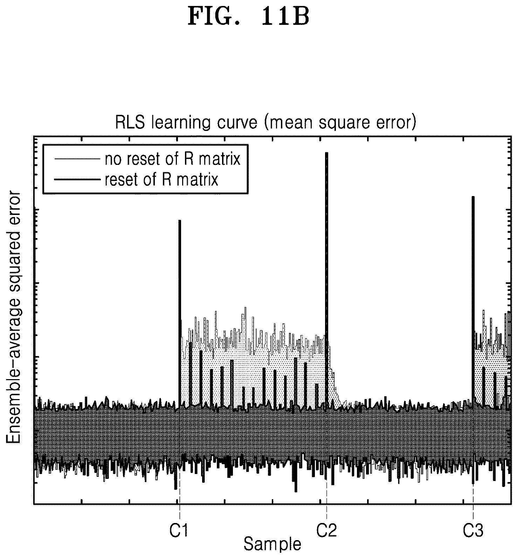

FIG. 11B is a graph for comparing and explaining the operation of an interference cancellation circuit, according to an embodiment and the operation of an interference cancellation circuit, according to a comparative embodiment.

In FIG. 11B, a light line graph represents the convergence speed of the error in the interference cancellation circuit according to the comparative embodiment (e.g., the RLS learning curve or mean square error), while a bold line graph in FIG. 11B represents the convergence speed of the error in the interference cancellation circuit 300 according to an embodiment (e.g., the DCD-RLS learning curve or mean square error). For example, the light line graph in FIG. 11B may represent the convergence speed of an adaptive filter (e.g., coefficients of an adaptive filter) according to a comparative embodiment without initializing the correlation matrix (R matrix). The bold line graph in FIG. 11B may represent the convergence speed of the adaptive filter 330 (e.g., coefficients of the adaptive filter 330) according to an embodiment that initializes a correlation matrix R matrix. In FIG. 11B, a transmission signal transmitted from a UL block (or at least one transmission filter) may be recognized as an interference signal from the perspective (e.g., in a self-interference situation) of a DL block (or a reception filter).

In FIG. 11B, it is assumed that the RB size of the transmission signal changes from 50 RB to 2 RB at the UL slot boundary C1, the RB size of the transmission signal changes from 2 RB to 50 RB at the UL slot boundary C2, and the RB size of the transmission signal changes from 50 RB to 2 RB at the UL slot boundary C3.

Referring to the light line graph of FIG. 11B, when the correlation matrix (R matrix) is not reset, it may be observed that the error of the interference cancellation circuit in the comparative embodiment does not converge quickly as the RB size of the interference signal changes. In other words, the convergence speed of the adaptive filter (e.g., the coefficients of the adaptive filter) becomes very slow.

Referring to the bold line graph of FIG. 11B, when the correlation matrix R matrix is reset (e.g., when the initial value of the correlation matrix R matrix is initialized), it may be observed that the error in the interference cancellation circuit 300 according to the embodiment converges quickly. Specifically, the convergence speed of the adaptive filter 330 (e.g., the coefficient of the adaptive filter 330) is very fast, even though the RB size of the interference signal is changed. In other words, the interference cancellation circuit 300 according to the embodiment may adaptively initialize a correlation matrix (R matrix), based on control information and transmission signal information (e.g., information about the RB size and offset position of the transmission signal).

Therefore, the interference cancellation circuit 300 according to the embodiment may effectively cancel an interference signal from the received signal by adaptively controlling parameters of an adaptive algorithm (e.g., initialization of a correlation matrix) depending on changes in an interference signal (or an interference estimation signal).

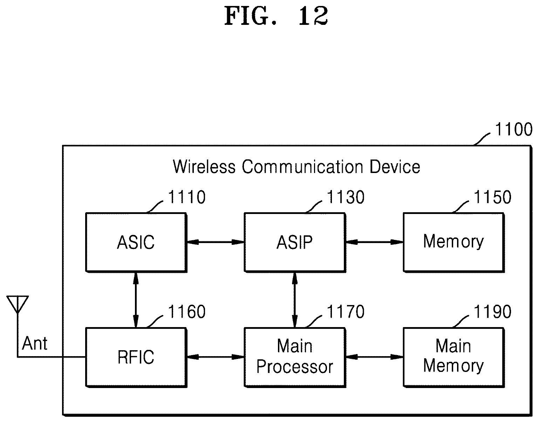

FIG. 12 is a block diagram of a wireless communication device according to an embodiment.

Referring to FIG. 12, a wireless communication device 1100 may include a modem and a radio frequency integrated circuit (RFIC) 1160, and the modem may include an application specific integrated circuit (ASIC) 1110, an application specific instruction set processor (ASIP) 1130, a memory 1150, a main processor 1170, and a main memory 1190. The wireless communication device 1100 of FIG. 12 may be an electronic device 1 according to an embodiment. The interference cancellation circuit 300 may be included in the RFIC (1160). However, it is not limited thereto, and the interference cancellation circuit 300 may be included in the modem depending on the embodiment.

The wireless communication device 1100 according to an embodiment may adaptively control at least one parameter of an adaptive algorithm (e.g., an RLS algorithm) depending on a change in an interference signal (interference estimation signal) based on transmission signal information about characteristics of a transmission signal received from a transmission filter. In this case, the transmission signal transmitted from at least one UL block (or at least one transmission filter) may be recognized as the interference signal from the perspective of a DL block (or a reception filter). Hereinafter, at least a portion of the transmission signal may be received by the DL block (or the reception filter) as an interference signal. The transmission signal information, here, is symbol unit information of an UL signal, and may include RB size information, offset change information, BWP setting change information, system BW change information, and information indicating whether CC is activated/deactivated. At least one parameter of the adaptive algorithm may include a regularization value, a variable forgetting factor, an initialization of a correlation matrix, and a number of taps of the adaptive filter.

For each delay signal in each transmission path, the CIR coefficient is estimated using the backpropagation technique (e.g., backpropagation technique based on Wirtinger derivative and chain rule), and the estimated CIR coefficient is reflected in the interference model to effectively remove the interference signal.

The RFIC 1160 is connected to an antenna Ant and may receive signals from the outside or transmit signals to the outside using a wireless communication network. The ASIP 1130 is an integrated circuit customized for a specific purpose, and may support a dedicated instruction set for a specific application and execute the instructions included in the instruction set. The memory 1150 may communicate with the ASIP 1130 and, as a non-transitory storage device, may store a plurality of instructions executed by the ASIP 1130. For example, the memory 1150 may include any type of memory accessible by ASIP 1130, such as, but not limited to, random access memory (RAM), read only memory (ROM), tape, magnetic disk, optical disk, volatile memory, nonvolatile memory, and combinations thereof.

The main processor 1170 may control the wireless communication device 1100 by executing a plurality of instructions. For example, the main processor 1170 may control the ASIC 1110 and the ASIP 1130, process data received over a wireless communications network, or process user input to the wireless communications device 1100.

The main memory 1190 may communicate with the main processor 1170 and, as a non-transitory storage device, may store a plurality of instructions executed by the main processor 1170. For example, the main memory 1190 may include any type of memory accessible by the main processor 1170, such as, but not limited to, RAM, ROM, tape, magnetic disks, optical disks, volatile memory, nonvolatile memory, and combinations thereof.

The foregoing embodiments are not to be construed as limiting. The present teaching can be readily applied to other types of apparatuses. Also, the description of the embodiments is intended to be illustrative, and not to limit the scope of the claims, and many alternatives, modifications, and variations will be apparent to those skilled in the art.

**Claims**

1. An interference cancellation circuit (300) comprising:

   a kernel generation circuit (310) configured to generate an interference model based on a transmission signal;
   an adaptive filter (330) configured to estimate coefficients for the interference model based on an adaptive algorithm to generate an interference estimation signal, and filter out the interference estimation signal from a received signal to generate an interference cancellation signal; and

a parameter control (PC) (350) circuit configured to generate a control signal for controlling at least one parameter of the adaptive algorithm based on transmission signal information of the transmission signal and transmit the control signal to the adaptive filter (330).

2. The interference cancellation circuit of claim 1,
wherein the at least one parameter comprises a regularization value, a variable forgetting factor, an initialization of a correlation matrix, and a number of taps of the adaptive filter.

3. The interference cancellation circuit of claim 1 or 2, wherein the transmission signal information is symbol unit information of an up-link (UL) signal, and comprises resource block (RB) size information, offset change information, change information of bandwidth part (BWP) setting, change information of system bandwidth (BW), and information indicating whether a carrier component (CC) is activated or deactivated.

4. The interference cancellation circuit of any preceding claim,

wherein at least a portion of the transmission signal received by a reception filter is an interference signal, and wherein the PC circuit (350) comprises a pre-process circuit (351) configured to:

generate control information comprising at least one of a bandwidth change amount of the interference signal, a change point in time of the interference signal, or a change position of the interference signal in a frequency domain, based on the transmission signal information; and
transmit the transmission signal information and the control information to a plurality of sub PC (352_1, 352_2, 352_3, 352_4) circuits of the PC circuit (350).

5. The interference cancellation circuit of claim 4, wherein the PC circuit (350) comprises a plurality of sub PC circuits (352_1, 352_2, 352_3, 352_4), and each of the plurality of sub PC circuits (352_1, 352_2, 352_3, 352_4) ) is configured to generate the control signal for controlling the at least one parameter corresponding to respective one of the plurality of sub PC circuits (352_1, 352_2, 352_3, 352_4), based on the transmission signal information and the control information.

6. The interference cancellation circuit of claim 4 or 5, wherein the PC circuit (350) is further configured to generate the control signal for controlling the regularization value of the adaptive algorithm, based on the transmission signal information, the control information, and down-link (DL) control information.

7. The interference cancellation circuit of claim 4, 5 or 6, wherein the PC circuit (350) is further configured to generate the control signal for controlling the variable forgetting factor or the initialization of the correlation matrix of the adaptive algorithm, based on the transmission signal information, the control information, and information indicating whether interference has occurred.

8. The interference cancellation circuit of any preceding claim, wherein the adaptive algorithm comprises a recursive least squares (RLS) algorithm.

9. A method of operating an interference cancellation circuit (300), the method comprising:

generating an interference model based on a transmission signal;
generating a control signal for controlling at least one parameter of an adaptive algorithm in an adaptive filter, based on transmission signal information received from a transmission filter (S110);
generating an interference estimation signal by estimating coefficients for the interference model, based on the adaptive algorithm updated through the control signal (S120); and
filtering out the interference estimation signal from a received signal (S130).

10. The method of claim 9, wherein the at least one parameter comprises a regularization value, a variable forgetting factor, an initialization of a correlation matrix, and a number of taps of the adaptive filter.

11. The method of claim 9 or 10, wherein the transmission signal information is symbol unit information of an up-link (UL) signal, and comprises resource block (RB) size information, offset change information, change information of bandwidth part (BWP) setting, change information of system bandwidth (BW), and information indicating whether carrier component (CC) is activated or deactivated.

**12.** The method of claim 10 or 11,

wherein at least a portion of the transmission signal received by a reception filter is an interference signal, and wherein the generating of the control signal comprises:

generating control information comprising at least one of a bandwidth change amount of the interference signal, a change point in time of the interference signal, or a change position of the interference signal in a frequency domain, based on the transmission signal information (S111); and

generating the control signal for controlling the at least one parameter based on the transmission signal information and the control information (S112).

**13.** The method of claim 12, wherein the generating of the control signal comprises generating the control signal for controlling the regularization value of the adaptive algorithm, based on the transmission signal information, the control information, and down-link (DL) control information.

**14.** The method of claim 12 or 13,
wherein the generating of the control signal further comprises generating the control signal to control the variable forgetting factor or the initialization of the correlation matrix, based on the transmission signal information, the control information, and information indicating whether interference occurs.

**15.** A wireless communication device (1100) comprising:

a transmission filter electrically connected to a first antenna (Ant);

a reception filter electrically connected to a second antenna (Ant); and

an interference cancellation circuit (300) configured to generate an interference estimation signal based on an adaptive algorithm, filter out the interference estimation signal from a received signal, and control at least one parameter of the adaptive algorithm based on transmission signal information received from the transmission filter.

# FIG. 1

EP 4 727 021 A1

# FIG. 2

**FIG. 3**

TX filter 1 (Aggressor #1) 110

RX filter (Victim #1)

TX filter 2 (Aggressor #2) 120

RX filter (Victim #2) 210

Interference cancellation circuit 300

DAC 111

ADC

DAC 121

ADC 213

PA 112 113

LNA

PA 122 123

LNA 211 212

TX self-interference

LO

124

TX1

TX2

# FIG. 4

Interference cancellation circuit — 300

Kernel Generation Circuit — 310

Adaptive Filter — 330

PC Circuit — 350

# FIG. 5

EP 4 727 021 A1

# FIG. 6

EP 4 727 021 A1

# FIG. 7

TX filter 1
(Aggressor #1)    110

1st Sub PC Circuit    152-1

2nd Sub PC Circuit    152-2

3rd Sub PC Circuit    152-3

4th Sub PC Circuit    152-4

TX filter 2
(Aggressor #2)    120

1st Sub PC Circuit    162-1

2nd Sub PC Circuit    162-2

3rd Sub PC Circuit    162-3

4th Sub PC Circuit    162-4

Adaptive
Filter    330

# FIG. 8

START

GENERATE INTERFERENCE MODEL BASED ON TRANSMISSION SIGNAL — S100

GENERATE CONTROL SIGNAL FOR CONTROLLING AT LEAST ONE PARAMETER OF ADAPTIVE ALGORITHM IN ADAPTIVE FILTER, BASED ON TRANSMISSION SIGNAL INFORMATION — S110

GENERATE INTERFERENCE ESTIMATION SIGNAL BY ESTIMATING COEFFICIENTS FOR INTERFERENCE MODEL, BASED ON ADAPTIVE ALGORITHM UPDATED DEPENDING ON CONTROL SIGNAL — S120

FILTERING INTERFERENCE ESTIMATION SIGNAL FROM RECEIVED SIGNAL — S130

END

# FIG. 9

S100

GENERATE CONTROL INFORMATION INCLUDING AT LEAST ONE OF BANDWIDTH CHANGE AMOUNT, BANDWIDTH CHANGE TIME, AND BANDWIDTH CHANGE LOCATION OF INTERFERENCE ESTIMATION SIGNAL, BASED ON TRANSMISSION SIGNAL INFORMATION — S111

GENERATE CONTROL SIGNAL FOR CONTROLLING AT LEAST ONE PARAMETER, BASED ON TRANSMISSION SIGNAL INFORMATION AND CONTROL INFORMATION — S112

S120

# FIG. 10A

RLS learning curve (mean square error)

# FIG. 10B

RLS learning curve (mean square error)

Ensemble-average squared error

- - - - - - RB=52 (regular=5e-5)
··············· RB=26 (regular=5e-5)
─────── RB=13 (regular=3e-4)
─────── RB=6 (regular=1e-3)

Sample

# FIG. 11A

RLS learning curve (mean square error)

# FIG. 11B

RLS learning curve (mean square error)

# FIG. 12

Wireless Communication Device — 1100

| | | |
|---|---|---|
| ASIC (1110) | ASIP (1130) | Memory (1150) |
| RFIC (1160) | Main Processor (1170) | Main Memory (1190) |

Ant

# EUROPEAN SEARCH REPORT

**Application Number**

EP 25 20 6311

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 387 111 A1 (SAMSUNG ELECTRONICS CO LTD [KR]) 19 June 2024 (2024-06-19) * abstract; figures 1A,2A * * paragraphs [0018] - [0035], [0047] - [0061] * ----- | 1-15 | INV. H04B1/12 H04B1/525 |
| X | EP 3 273 606 B1 (APPLE INC [US]) 26 May 2021 (2021-05-26) * figures 1,6 * * paragraphs [0038] - [0051] * ----- | 1-15 | |
| A | AUER CHRISTINA ET AL: "Self-Interference Cancellation in LTE/5G Transceivers with Sliding Window Kernel Recursive Least Squares Filters", 2021 55TH ASILOMAR CONFERENCE ON SIGNALS, SYSTEMS, AND COMPUTERS, [Online] 31 October 2021 (2021-10-31), pages 976-982, XP093175283, DOI: 10.1109/IEEECONF53345.2021.9723127 Retrieved from the Internet: URL:https://ieeexplore.ieee.org/stampPDF/g etPDF.jsp?tp=&arnumber=9723127&ref=aHR0cHM 6Ly9pZWVleHBsb3JlLmllZWUub3JnL2RvY3VtZW50L zk3MjMxMjc=> * the whole document * ----- | 1-15 | **TECHNICAL FIELDS SEARCHED (IPC)**<br><br>H04B |

The present search report has been drawn up for all claims

| Place of search | Date of completion of the search | Examiner |
|---|---|---|
| Munich | 8 February 2026 | Almenar Muñoz, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 6311

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2026

| Patent document cited in search report | | Publication date | Patent family member(s) | | Publication date |
|---|---|---|---|---|---|
| EP 4387111 | A1 | 19-06-2024 | CN | 118214450 A | 18-06-2024 |
| | | | EP | 4387111 A1 | 19-06-2024 |
| | | | KR | 20240093216 A | 24-06-2024 |
| | | | US | 2024204977 A1 | 20-06-2024 |
| EP 3273606 | B1 | 26-05-2021 | CN | 107645316 A | 30-01-2018 |
| | | | EP | 3273606 A1 | 24-01-2018 |
| | | | US | 2018026775 A1 | 25-01-2018 |
| | | | US | 2019229884 A1 | 25-07-2019 |
| | | | US | 2023344614 A1 | 26-10-2023 |
| | | | WO | 2018017143 A2 | 25-01-2018 |

EPO FORM P0459

For more details about this annex : see Official Journal of the European Patent Office, No. 12/82